# EUROPÄISCHE PATENTANMELDUNG

(11) **EP 2 463 900 A2**
(43) Veröffentlichungstag der Anmeldung: **13.06.2012**
(21) Anmeldenummer: 11185592.0
(22) Anmeldetag: 18.10.2011
(51) Int. Cl.: H01L 23/31, H01L 21/60, H01L 23/29

(54) **Verfahren zur Herstellung einer Schaltungsanordnung**

(30) Priorität: 07.12.2010 DE 102010062547
(71) Anmelder: SEMIKRON Elektronik GmbH & Co. KG, 90431 Nürnberg (DE)
(72) Erfinder: Dr. Braml, Heiko, 91346 Wiesenttal (DE); Göbl, Christian, 90441 Nürnberg (DE)

(57) **Zusammenfassung**

Es wird ein Verfahren zur Herstellung einer Schaltungsanordnung (10) mit einem Substrat (12) und mit einer flexiblen Verbindungseinrichtung (16) beschrieben, wobei zwischen der Verbindungseinrichtung (16) und dem Substrat (12) ein Isolationsmaterial (18) vorgesehen ist, das auf das Substrat (12) und/oder auf die flexible Verbindungseinrichtung (16) mindestens einlagig aufgedruckt wird.

## Beschreibung

Die Erfindung betrifft ein Verfahren zur Herstellung einer Schaltungsanordnung mit einem Substrat und mit einer flexiblen Verbindungseinrichtung, wobei zwischen der Verbindungseinrichtung und dem Substrat ein Isolationsmaterial vorgesehen ist.

Ein derartiges Verfahren ist aus der DE 10 2007 006 706 A1 bekannt. Bei diesem bekannten Verfahren wird das Isolationsmaterial durch Gießen oder Spritzen auf das Substrat aufgebracht. Als Isolationsmaterial kommt dort vorzugsweise eine Silikonverbindung, speziell ein Silikonkautschuk, zur Anwendung. An das Spritz- oder Gießverfahren schließt sich in vorteilhafter Weise eine Vernetzung beispielsweise durch UV-Belichtung an. Dabei ist zu beachten, dass das Isolationsmaterial während des Spritzens oder Gießens blasenfrei auf das Substrat aufgebracht werden muß. Zu diesem Zwecke wird das Isolationsmaterial entweder unter Vakuum verarbeitet oder nach dem Aufbringen auf das Substrat eine Evakuierung durchgeführt. Das stellt einen nicht zu vernachlässigenden Geräte- und Arbeitsaufwand dar. Silikonkautschuk bzw. Silikongel besitzt zwar gute elektrische Isolationseigenschaften, es ist jedoch gegen Feuchtigkeitseinflüsse nicht zuverlässig dicht.

Die DE 10 2007 044 620 A1 offenbart eine Anordnung mit einer Verbindungseinrichtung zur elektrisch leitenden Verbindung mit mindestens einem Halbleiterbauelement, und mit einem Füllstoff. Die Verbindungseinrichtung ist als Folienverbund aus mindestens einer isolierenden Folie und zwei elektrisch leitenden Folien ausgebildet, die an den beiden voneinander abgewandten Seiten der isolierenden Folie vorgesehen sind. Mindestens eine elektrisch leitende Folie ist in sich strukturiert, um Leiterahnen auszubilden. Der Füllstoff befindet sich zwischen der Verbindungseinrichtung und dem mindestens einen Halbleiterbauelement. Als Füllstoff kommt dort ein niederviskoser Füllstoff zur Anwendung, um ein kapillares Unterfüllen zu bewirken. Um das kapillare Unterfüllen zu optimieren, wird dort vorgeschlagen, dass mindestens einem Halbleiterbauelement mindestens eine Aussparung in der jeweils leitenden Folie zugeordnet ist, wobei die mindestens eine Aussparung zumindest teilweise in dem vom Halbleiterbauelement überdeckten Bereich der elektrisch leitenden Folie vorgesehen ist.

Die WO 03/030247 A2 beschreibt ein Verfahren zum Kontaktieren mindestens einer elektrischen Kontaktfläche auf einer Oberfläche eines Substrates, wobei eine Folie aus einem elektrisch isolierenden Kunststoffmaterial auf die Oberfläche des Substrates unter Vakuum auflaminiert wird, so dass die Folie die Oberfläche mit der mindestens einen Kontaktfläche eng anliegend bedeckt und auf der Oberfläche haftet. Anschließend erfolgt ein Freilegen der mindestens einen zu kontaktierenden Kontaktfläche auf der Oberfläche durch Öffnen von Fenstern in der Folie. Danach erfolgt ein flächiges Kontaktieren jeder freigelegten Kontaktfläche mit einer Schicht aus elektrisch leitendem Material.

Der Erfindung liegt die Aufgabe zugrunde, ein Verfahren der eingangs genannten Art zu schaffen, wobei zwischen der flexiblen Verbindungseinrichtung und dem Substrat auf einfache Weise eine gute elektrische Isolation verwirklicht wird, wobei die Dichtheit des Systems im Vergleich zu einem Isolations-Verguss verbessert ist.

Diese Aufgabe wird erfindungsgemäß durch die Merkmale des Anspruches 1, d.h. dadurch gelöst, dass das Isolationsmaterial auf das Substrat und/oder auf die flexible Verbindungseinrichtung aufgedruckt wird. Das kann durch Stempeldruck, Maskendruck oder vorzugsweise durch Siebdruck erfolgen.

Erfindungsgemäß kann das Isolationsmaterial auf das Substrat und/oder auf die flexible Verbindungseinrichtung einlagig aufgedruckt werden. Zweckmäßig kann es sein, wenn das Isolationsmaterial auf das Substrat und/oder auf die flexible Verbindungseinrichtung mehrlagig aufgedruckt wird. Hierbei kann das Isolationsmaterial in den einzelnen Drucklagen die gleichen oder unterschiedliche Dicken und/oder die gleichen oder unterschiedliche Flächenausdehnungen aufweisen. Insbesondere dann, wenn die einzelnen Drucklagen unterschiedliche Dicken und unterschiedliche Flächenausdehnungen aufweisen, ist es beispielsweise möglich, die Schichtdicke des Isolationsmaterials den jeweiligen schaltungsgemäßen Gegebenheiten entsprechend lokal zu vergrößern.

Bevorzugte Aus- bzw. Weiterbildungen des erfindungsgemäßen Verfahrens sind in den Unteransprüchen 5 bis 9 gekennzeichnet.

Bei dem Isolationsmaterial handelt es sich beispielsweise um bekannte Co-oder Heteropolymere.

Durch das erfindungsgemäß angewandet Druckverfahren wird eine präzise und gute elektrische Isolation benachbarter Leiter sichergestellt so dass die erfindungsgemäß hergestellte Schaltungsanordnung gleichsam hermetisch abgedichtet werden kann.

Das erfindungsgemäße Verfahren weist den weiteren Vorteil auf, dass auch Großnutzen, d.h. eine Anzahl Schaltungsanordnungen in einem gemeinsamen Verfahrensschritt mit dem Isolationsmaterial bedruckt werden können. Danach erfolgt in einem Sinterprozess ein Verbacken der Komponenten zur erfindungsgemäßen Schaltungsanordnung. In vorteilhafter Weise entfällt erfindungsgemäß ein sekundärer Silikon-Verguss; auch Silikon-Dämme sind entbehrlich.

Erfindungsgemäß kann ein Substrat verwendet werden, das nur eine schaltstrukturierte Metalllage aufweist. Desgleichen ist es möglich, dass ein Substrat verwendet wird, das an der schaltstrukturierten Metalllage mindestens ein chipförmiges Halbleiterbauelement aufweist. Bei dem Halbleiterbauelement handelt es sich vorzugsweise um ein Leistungshalbleiterbauelement.

Bei dem Aufdrucken des Isolationsmaterials auf das Substrat handelt es sich um ein Aufdrucken des Isolationsmaterials auf die Leiterbahnen und/oder auf die Isolationslage des Substrates und/oder auf das mindestens eine Halbleiterbauelement.

Desgleichen ist es erfindungsgemäß möglich, dass für einen Großnutzen ein Mehrfach-Substrat verwendet wird, wobei mindestens eines der Substrate oder jedes einzelne Substrat mindestens ein Halbleiterbauelement aufweist.

Bei dem erfindungsgemäßen Verfahren kann eine einlagige flexible Verbindungseinrichtung verwendet werden, bei der es sich beispielsweise um eine schaltstrukturierte Metalllage handelt. Eine andere Möglichkeit besteht darin, dass eine mehrlagige flexible Verbindungseinrichtung, bestehend aus einer Isolierstofflage und je einer schaltstrukturierten Metalllage an beiden voneinander abgewandten Seiten der Isolierstofflage verwendet wird.

Weitere Einzelheiten, Merkmale und Vorteile ergeben sich aus der nachfolgenden Beschreibung in Verbindung mit der anliegenden Zeichnung.

Es zeigen:
Figur 1 abschnittweise in einer vergrößerten Schnittansicht eine erste Ausführungsform der erfindungsgemäß hergestellten Schaltungsanordnung, und
Figur 2 in einer der Figur 1 ähnlichen abschnittweisen Schnittdarstellung eine zweite Ausführungsform der erfindungsgemäß hergestellten Schaltungsanordnung.

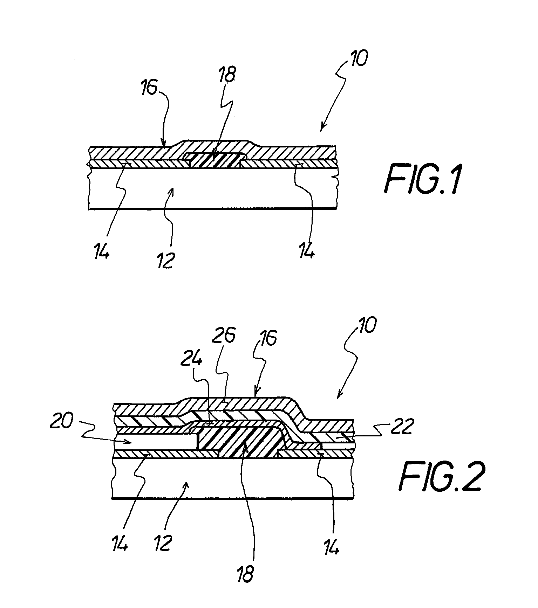

Figur 1 zeigt abschnittweise, nicht maßstabgetreu eine Ausbildung der erfindungsgemäß hergestellten Schaltungsanordnung 10 mit einem Substrat 12, bei dem es sich beispielsweise um ein DCB- Substrat handelt. Das Substrat 12 weist eine schaltstrukturierte Metalllage 14 auf. Zur schaltgerechten Verbindung der Metalllage 14 ist eine flexible Verbindungseinrichtung 16 vorgesehen. Die Verbindungseinrichtung 16 ist einlagig ausgebildet.

Zwischen der Verbindungseinrichtung 16 und dem Substrat 12 ist ein Isolationsmaterial 18 vorgesehen. Das Isolationsmaterial 18 wird auf das Substrat 12 und/oder auf die flexible Verbindungseinrichtung 16 aufgebracht. Das geschieht vorzugsweise durch Siebdrucken. Anschließend wird die Verbindungseinrichtung 16 auf dem Substrat 12 genau richtig positioniert angeordnet, wonach in einem Sinterprozess ein Verbacken zur Schaltungsanordnung 10 erfolgt.

Figur 2 verdeutlicht in einer der Figur1 ähnlichen schematischen Darstellung eine Ausbildung der Schaltungsanordnung 10 mit einem chipförmigen Halbleiterbauelement 20 und mit einer Verbindungseinrichtung 16, die eine Isolierstofflage 22 aufweist. An den beiden voneinander abgewandten Seiten der Isolierstofflage 22 ist jeweils eine schaltstrukturierte Metalllage 24, 26 vorgesehen. Die Metalllage 24 ist dem Halbleiterbauelement 20 und der schaltstrukturierten Metalllage 14 des Substrates 10 zugeordnet, um eine entsprechende Schaltverbindung zu realisieren.

Mit der Bezugsziffer 18 ist auch in Figur 2 ein Isolationsmaterial bezeichnet, das auf das Substrat 12 und/oder auf die Metalllage 24 der flexiblen, mehrlagigen Verbindungseinrichtung 16 vorzugsweise durch Siebdrucken aufgebracht wird. Die Verbindungseinrichtung wird dann auf dem Substrat 12 richtig positioniert angeordnet. Anschließend erfolgt in einem Sinterprozess ein Verbacken zur Schaltungsanordnung 10.

### Bezuasziffernliste:

- 10: Schaltungsanordnung
- 12: Substrat (von 10)
- 14: Metalllage (an 12)
- 16: Verbindungseinrichtung (von 10)
- 18: Isolationsmaterial (zwischen 16 und 12)
- 20: Halbleiterbauelement (von 10 an 14)
- 22: Isolierstofflage (von 16)
- 24: Metalllage (an 22)
- 26: Metalllage (an 22)

## Patentansprüche

1. Verfahren zur Herstellung einer Schaltungsanordnung (10) mit einem Substrat (12) und mit einer flexiblen Verbindungseinrichtung (16), wobei zwischen der Verbindungseinrichtung (16) und dem Substrat (12) ein Isolationsmaterial (18) vorgesehen ist,
**dadurch gekennzeichnet,**
**dass** das Isolationsmaterial (18) auf das Substrat (12) und/oder auf die flexible Verbindungseinrichtung (16) aufgedruckt wird.

2. Verfahren nach Anspruch 1,
**dadurch gekennzeichnet,**
**dass** das Isolationsmaterial (18) auf das Substrat (12) und/oder auf die flexible Verbindungseinrichtung (16) einlagig aufgedruckt wird.

3. Verfahren nach Anspruch 1,
**dadurch gekennzeichnet,**
**dass** das Isolationsmaterial (18) auf das Substrat (12) und/oder auf die flexible Verbindungseinrichtung (16) mehrlagig aufgedruckt wird.

4. Verfahren nach Anspruch 1,
**dadurch gekennzeichnet,**
**dass** das Isolationsmaterial (18) auf das Substrat (12) und/oder auf die flexible Verbindungseinrichtung (16) in den einzelnen Drucklagen mit gleichen oder unterschiedlichen Dicken und/oder mit gleichen oder unterschiedlichen Flächenausdehnungen aufgedruckt wird.

5. Verfahren nach Anspruch 1,
**dadurch gekennzeichnet,**
**dass** das Isolationsmaterial (18) auf das Substrat (12) und/oder auf die flexible Verbindungseinrichtung (16) durch Stempeldrucken oder Maskendrucken oder vorzugsweise durch Siebdrucken aufgebracht wird.

6. Verfahren nach Anspruch 1,
**dadurch gekennzeichnet,**
**dass** ein Substrat (12) verwendet wird, das mindestens ein chipförmiges Halbleiterbauelement (20) aufweist.

7. Verfahren nach Anspruch 1,
**dadurch gekennzeichnet,**
**dass** ein Mehrfach-Substrat (12) aus einer Anzahl Substrate (12) verwendet wird, wobei mindestens ein Substrat (12) oder wobei jedes einzelne Substrat (12) mindestens ein Halbleiterbauelement (20) aufweist.

8. Verfahren nach Anspruch 1,
**dadurch gekennzeichnet,**
**dass** eine einlagige flexible Verbindungseinrichtung (16) verwendet wird.

9. Verfahren nach Anspruch 1,
**dadurch gekennzeichnet,**
**dass** eine mehrlagige flexible Verbindungseinrichtung (16), bestehend aus einer Isolierstofflage (22) und je einer schaltstrukturierten Metalllage (24, 26) an beiden voneinander abgewandten Seiten der Isolierstofflage (22), verwendet wird.
